# DEMANDE DE BREVET EUROPEEN

(11) **EP 2 581 475 A1**
(43) Date de publication de la demande: **17.04.2013**
(21) Numéro de dépôt: 12187477.0
(22) Date de dépôt: 05.10.2012
(51) Int. Cl.: C30B 29/16, C30B 31/02, C30B 31/22, C30B 33/02, H01L 21/46

(54) **Procédé de préparation d'oxyde de zinc ZnO de type p ou de ZnMgO de type p**

(30) Priorité: 10.10.2011 FR 1159121
(71) Demandeur: Commissariat à l'Énergie Atomique et aux Énergies Alternatives, 75015 Paris (FR)
(72) Inventeur: Feuillet, Guy, 38410 Saint-Martin d'Uriage (FR); Granier, Carole, 38140 Apprieu (FR)
(74) Mandataire: Augarde, Eric

(57) **Abrégé**

Procédé de préparation d'oxyde de zinc ZnO de type p ou de ZnMgO de type p, comprenant au moins la succession des deux étapes a) et b) suivantes:
a) dépôt de silice) éventuellement dopée par au moins un élément dopant de la colonne V de la classification périodique des éléments sur une surface d'un substrat en ZnO de type n ou en ZnMgO de type n ;
b) recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice ; et
une étape de dopage de ladite partie du substrat adjacente à la silice et comprenant les lacunes de Zinc par au moins un élément dopant de la colonne V de la classification périodique des éléments durant l'étape b) ou à l'issue de l'étape b).

## Description

### DOMAINE TECHNIQUE

L'invention concerne un procédé de préparation d'oxyde de Zinc ZnO de type p ou de ZnMgO de type p.

Le domaine technique de l'invention peut, de manière générale, être défini comme celui du dopage des matériaux semi-conducteurs.

Plus précisément, le domaine technique de l'invention peut être défini comme celui de la préparation, fabrication d'oxyde de zinc ZnO ou d'alliage ZnMgO dopé de type p, c'est-à-dire présentant une conductivité de type p, à partir de ZnO ou d'alliage ZnMgO non dopé, c'est-à-dire présentant une conductivité de type n intrinsèque.

Ce dopage de type p peut être en particulier un dopage par des éléments de la colonne V de la classification périodique des éléments, tels que As, P, et éventuellement Sb.

L'oxyde de Zinc ZnO est un matériau semiconducteur qui possède de nombreuses applications en opto-électronique, en particulier dans les LEDs pour l'éclairage sous la forme de couches minces 2D et de nanofils.

Afin de réaliser des dispositifs bipolaires, et notamment des diodes électroluminescentes dans le proche UV, dont les applications industrielles sont potentiellement très importantes, il est nécessaire de réaliser le dopage de type p de l'oxyde de zinc ZnO.

Or, on sait qu'il existe fréquemment, ce que l'on peut appeler une asymétrie du dopage des matériaux semi-conducteurs, c'est-à-dire qu'un type de dopage par exemple le dopage n est plus facile à obtenir que l'autre type de dopage, par exemple le dopage p.

C'est précisément le cas du ZnO.

### ÉTAT DE LA TECHNIQUE ANTÉRIEURE

La préparation d'oxyde de zinc ZnO dopé de type p s'est avérée difficile.

En effet, le dopage de type p du ZnO se heurte toujours à des difficultés importantes, en raison notamment de l'existence d'impuretés intrinsèques et/ou extrinsèques responsables du dopage n résiduel du ZnO.

Les impuretés intrinsèques de type donneur sont essentiellement constituées par des interstitiels du cation Zn (« Znᵢ ») et par des lacunes de l'anion oxygène (« V_{O} »), dont l'énergie de formation est négative lorsque le niveau de fermi Ef se rapproche de la bande de valence.

Au contraire, la théorie prévoit que les accepteurs intrinsèques, à savoir les lacunes du Zinc (« V_{Z} ») et les interstitiels de l'oxygène (« Oᵢ »), ont des énergies de formation positives lorsque, de même, le niveau de fermi Ef se rapproche de la bande de valence.

Il s'agit ici de calculs à l'équilibre thermodynamique.

Les impuretés extrinsèques quant à elles sont principalement l'hydrogène, le lithium et l'aluminium, qui sont très souvent présents dans les substrats et les couches épitaxiées, et qui donnent lieu à des niveaux proches de la bande de conduction.

Ces impuretés intrinsèques et extrinsèques sont des « tueurs d'accepteurs » (ou « *acceptor killers* » en langue anglaise) qui doivent être éliminées lorsque l'on souhaite réaliser un dopage de type p du ZnO.

Si l'on s'intéresse plus particulièrement aux impuretés intrinsèques (Znᵢ et V_{O}). Une façon d'en limiter la présence consiste par exemple à utiliser des conditions de croissance riche en oxygène, à la fois pour le matériau massif et les couches épitaxiées.

Mais les conditions de croissance sont souvent fixées sur la base de considérations relatives à l'obtention de la structure cristalline recherchée et à l'optimisation de la surface de croissance. Ces conditions de croissances peuvent être antinomiques avec des conditions permettant un ajustement de la stoechiométrie et assurant le dopage du matériau.

Une autre façon de limiter la présence des impuretés intrinsèques consiste à s'éloigner des conditions d'équilibre thermodynamique.

Ainsi, le document de Tsukazaki et al. Nat, Mat. 4, 42, 2005 décrit-il un procédé dans lequel des couches de ZnO sont épitaxiées en alternant des cycles à basse température pour forcer l'incorporation du dopant azote, et des cycles à haute température pour améliorer le front de croissance et la cristallinité de la couche.

Des dopages p de l'ordre de 10^{E}16 ont ainsi été réalisés, et des jonctions p/n avec électroluminescence ont été obtenues.

Ce procédé repose cependant sur l'utilisation du dopant azote en site oxygène, dont l'énergie d'activation est forte, à savoir de l'ordre de 260 meV à 1,4 eV selon les différentes estimations théoriques.

Ce procédé donne donc des densités de trous faibles à température ambiante. De plus, le manque de stabilité de l'azote dans la matrice de ZnO et la formation très probable d'azote diatomique N₂ rendent improbables la réalisation de dispositifs stables dans le temps en mettant en oeuvre ce procédé de dopage p.

Il faut donc tenter d'utiliser d'autres accepteurs à énergie d'activation plus faible pour créer plus de trous et pour s'assurer que la future jonction p-n ne sera pas déséquilibrée, amenant à des phénomènes d'injection d'électrons en excès au-travers de la jonction p-n sans recombinaison radiative.

Ceci élimine a priori les autres éléments V en substitution de l'oxygène, dont les énergies de formation sont élevées et dont les énergies d'ionisation sont encore supérieures à celles de l'azote.

Par exemple, cette énergie d'ionisation est de 900 meV pour le Phosphore et 1,5 eV pour l'Arsenic comme cela est mentionné dans le document de Ü Özgur et al., Journal of Appl. Phys., 98, 041301 (2005) et dans le document de C. H. Park, S. B. Zhang, and S.-H. Wei, Phys. Rev. B 66, 073202 (2002).

Par contre, la théorie, exposée par exemple dans le document de Limpijumnong, S. B. Zhang, S. H. Wei, et C. H. Park, Phys. Rev. Lett. 92, 155504 (2004) prévoit que les complexes accepteurs qui associent des lacunes de cation et des éléments de la colonne V tels que P, As et Sb, en substitution du Zn aient des énergies d'ionisation plus faibles, typiquement de l'ordre de 150-160meV .

Les complexes considérés ici sont du type (2V_{Zn}, As_{Zn}) ou (2V_{Zn}, P_{Zn}).

Les données expérimentales vont dans ce sens.

Ainsi, le document de Ryu et al., Appl. Phys. Lett. 83, 87(2003), le document de Allenic et al., J Phys. D 2008, et plus récemment le document de B.J. Kim et al., Appl. Phys. Lett. 94, 103506 (2009), avancent des énergies d'activation de l'ordre de 120meV pour l'arsenic.

Ces énergies d'ionisation sont alors suffisamment faibles pour induire une densité de trous permettant d'éviter l'injection d'électrons en excès au niveau de la jonction.

Mais, pour être efficace, cette méthode de dopage p, par formation de complexes accepteurs associés à des lacunes de Zn, nécessite non seulement que les impuretés résiduelles de type n, à savoir V_{O} et Znᵢ soient réduites autant que possible, mais aussi que soient effectivement présentes des lacunes de ce cation.

On sait en effet (voir par exemple le document de A. Zunger , Appl. Phys. Lett. 83 n°1, 2003 et le document de A. Janotti et C.G. Van de Walle Rep. Prog. Phys. 72 (2009) 126501) comme on l'a déjà précisé plus haut, que les énergies de formation des lacunes de Zn sont positives lorsque le niveau de Fermi se rapproche de la bande de valence.

Les complexes considérés ici impliquant 3 lacunes de Zn, on conçoit donc aisément que leur formation sera très difficile énergétiquement.

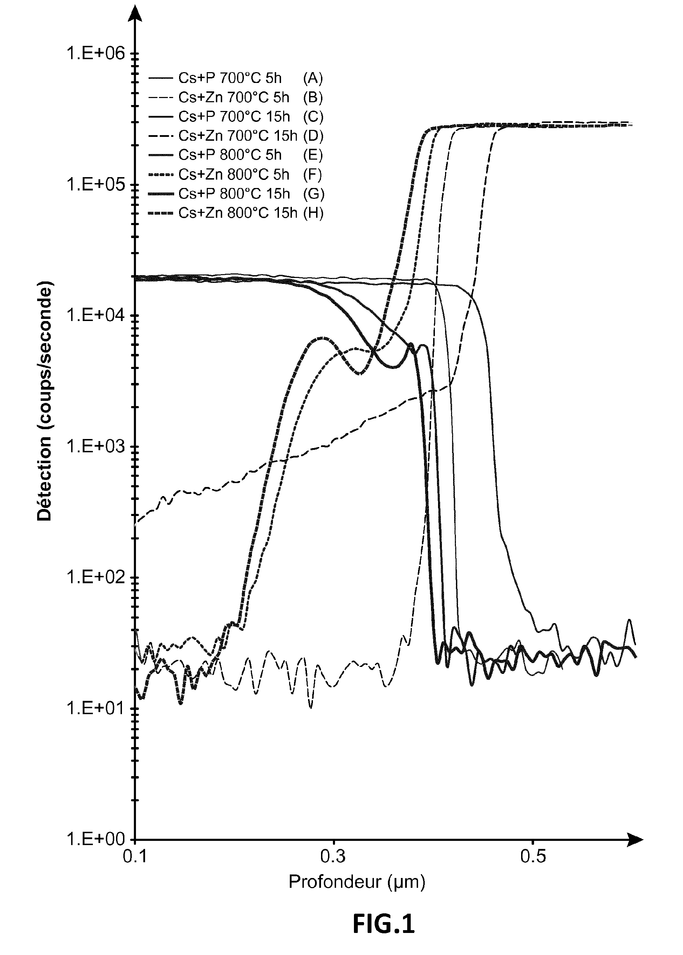

Pour mieux appréhender la situation, on pourra se reporter à la figure 1 du document de A. Janotti et C.G. Van de Walle, Rep. Prog. Phys. 72 (2009) 126501, qui donne les énergies de formation calculées pour les différentes espèces de défauts intrinsèques, natifs, dans ZnO, en fonction de la position du niveau de Fermi et pour des conditions « riches O » ou « riches Zn ».

En conclusion, les procédés utilisés jusqu'alors pour réaliser un dopage p du ZnO consistent à se placer dans des conditions riches en oxygène pendant la croissance ou à faire des traitements post-croissance sous atmosphère d'oxygène. Des dopages de l'ordre de 10^{E}17/cm³ ont ainsi été obtenus.

Mais, comme cela a déjà été mentionné plus haut, les conditions de croissance sont souvent fixées en tenant compte de considérations visant à obtenir la structure cristalline recherchée et à optimiser la surface. Ces conditions ne sont pas toujours et même souvent les conditions qui favorisent la formation de lacunes de Zn.

Il existe donc au regard de ce qui précède, un besoin non encore satisfait pour un procédé de préparation d'oxyde de zinc ZnO de type p qui permette un dopage efficace du ZnO.

Il existe également un besoin pour un procédé de préparation d'oxyde de Zinc ZnO de type p qui soit simple et fiable.

Plus précisément, il existe un besoin pour un pour un procédé de préparation d'oxyde de Zinc ZnO de type p dans lequel, préalablement au dopage de type p, les impuretés intrinsèques résiduelles de type n telles que les lacunes d'oxygène V_{O} et les interstitiels de Zinc du ZnO soient éliminées ou du moins réduites au maximum et des lacunes de Zinc soient créées de façon à ce qu'ensuite un dopage efficace de type p par formation de complexes accepteurs liant les lacunes de zinc et les éléments dopants de la colonne V de la classification périodique des éléments puisse être effectué.

Le but de la présente invention est de fournir un procédé de préparation d'oxyde de Zinc ZnO de type p qui réponde entre autres aux besoins énumérés plus haut.

Le but de la présente invention est encore de fournir un procédé de préparation d'oxyde de Zinc ZnO de type p qui ne présente pas les inconvénients, défauts, limitations et désavantages des procédés de l'art antérieur et qui apporte une solution aux problèmes des procédés de l'art antérieur.

### EXPOSÉ DE L'INVENTION

Ce but, et d'autres encore, sont atteints, conformément à l'invention par un procédé de préparation d'oxyde de zinc ZnO de type p ou de ZnMgO de type p, comprenant au moins la succession des deux étapes a) et b) suivante :
a) dépôt de silice, éventuellement dopée par au moins un élément dopant de la colonne V de la classification périodique des éléments, sur une surface d'un substrat en ZnO de type n ou en ZnMgO de type n ;
b) recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice ; et
   une étape de dopage de ladite partie du substrat adjacente à la silice et comprenant les lacunes de Zinc par au moins un élément dopant de la colonne V de la classification périodique des éléments durant l'étape b) ou à l'issue de l'étape b).

Selon l'invention, par ZnO de type n ou ZnMgO de type n, on entend que ce ZnO ou ce ZnMgO présente intrinsèquement une conductivité de type n, c'est-à-dire que ce ZnO ou ce ZnMgO n'a pas été intentionnellement, volontairement dopé de type n mais présente cette conductivité de type n de manière intrinsèque, inhérente.

On désigne également ce ZnO ou ce ZnMgO dopé de type n non intentionnellement, non volontairement par les termes ZnO ou ZnMgO non (intentionnellement) dopé.

Avantageusement, le substrat en ZnO de type n ou en ZnMgO de type n peut se présenter sous la forme d'un substrat massif monolithique, d'une couche, par exemple d'une couche épitaxiée, d'au moins un nanofil, ou d'une hétérostructure à puits quantiques de ZnO.

Avantageusement, le substrat peut se présenter sous la forme d'une hétérostructure à puits quantique de ZnO dans des couches d'alliages ZnMgO avec une couche inférieure de ZnMgO dopée de type n et une couche supérieure de ZnMgO non dopée sur la face supérieure de laquelle on effectue le dépôt de silice.

Avantageusement, l'élément dopant de la colonne V de la classification périodique des éléments peut être choisi parmi P, As et Sb.

Avantageusement, le dépôt de silice peut être réalisé sous la forme d'une couche, l'épaisseur de ladite couche étant de préférence de 50 à 500 nm, de préférence encore de 100 à 500 nm.

Avantageusement, lors de l'étape b), le recuit est réalisé à une température de 400°C à 1000°C, de préférence de 600°C à 950°C, de préférence encore de 700°C à 800°C, pendant une durée de 30 mn à 15 heures.

Avantageusement, ladite partie du substrat adjacente à la silice s'étend sur une épaisseur de 50 à 500 nm depuis une interface entre la silice et le ZnO ou le ZnMgO.

Cette épaisseur correspond généralement à l'épaisseur de la future zone p que l'on souhaite créer dans le substrat.

Avantageusement, le dopage de ladite partie du substrat adjacente à la silice par au moins un élément dopant de la colonne V de la classification périodique des éléments est réalisé par diffusion ou par implantation dudit élément. Le procédé selon l'invention comprend une suite spécifique d'étapes spécifiques qui n'a jamais été décrite ou suggérée dans l'art antérieur.

En particulier, la succession spécifique des étapes a) et b) n'a jamais été décrite ni suggérée dans l'art antérieur.

Le procédé selon l'invention répond entre autres aux besoins énumérés plus haut et atteint les buts mentionnés ci-dessus.

Le procédé selon l'invention ne présente pas les inconvénients des procédés de l'art antérieur et apporte une solution aux problèmes des procédés de l'art antérieur.

Le procédé selon l'invention permet de favoriser la formation de complexes accepteurs dans le ZnO, complexes dont a vu plus haut que l'énergie d'activation était suffisamment faible, à savoir de l'ordre de 120-160meV, pour assurer une activation forte des dopants introduits lors du dopage, que ce dopage soit réalisé par un procédé de dopage par implantation, ou par un procédé de dopage par diffusion.

Rappelons que ces complexes accepteurs lient des lacunes de Zinc et des éléments de la colonne V de la classification périodique des éléments qui sont placés sur ces lacunes de Zinc.

Afin de favoriser la formation de ces complexes, le procédé selon l'invention commence tout d'abord lors des étapes a) et b) par favoriser fortement la formation de lacunes de Zinc dans le ZnO.

Lors de ces mêmes étapes a) et b), outre la formation des lacunes de Zinc, le procédé selon l'invention assure également l'élimination des interstitiels de Zinc, qui sont des donneurs résiduels constituant un facteur limitant pour le dopage p.

Le procédé selon l'invention repose ensuite sur l'incorporation dans le ZnO, lors de l'étape b) ou à l'issue de l'étape b), d'éléments dopants de la colonne V, qui viennent occuper certains des sites de Zn vacants.

Cette incorporation ou dopage peut se faire notamment par des procédés *ex-situ* du type diffusion ou implantation. Il a été mis en évidence, selon l'invention, que le ZnO d'un côté, et la silice SiO₂ de l'autre, « interagissent » fortement et que les phénomènes d'interdiffusion à leurs interfaces sont faciles.

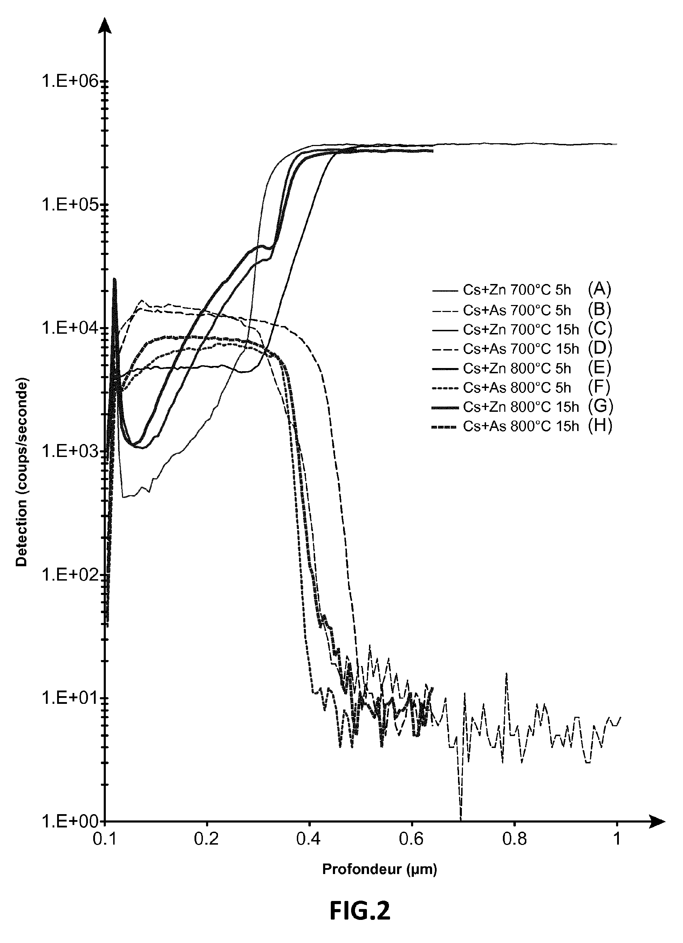

Les analyses par spectrométrie de masse des ions secondaires (« SIMS ») (voir Figure 1 dans le cas d'un dépôt de silice dopée phosphore et voir Figure 2 dans le cas d'un dépôt de silice dopée arsenic), notamment, réalisées par les inventeurs, mettent en évidence que le Zinc a une forte tendance à diffuser vers le SiO₂ lorsque celui-ci est déposé sur le ZnO puis qu'un recuit est effectué, à une température suffisante et pendant une durée suffisante, de préférence à des températures de entre 700°C et 800°C pendant des durées de 30 mn à 15 heures. Il a également été mis en en évidence, par une analyse par diffraction des rayons X des poudres, la formation d'une phase cristalline du type silicate de zinc, Zn₂SiO₄, à l'interface entre le ZnO et le SiO₂, après recuit d'un dépôt de SiO₂ sur ZnO.

Ces silicates sont bien connus et résultent de l'interaction entre SiO₂ et de nombreux oxydes métalliques.

Ces observations sont en accord avec les valeurs très basses, trouvées dans la littérature, pour les énergies d'activation d'autodiffusion des interstitiels de Zn : typiquement de l'ordre de 0,2-0,3 eV, comme cela est indiqué dans le document de Erhart et al., Appl.Phys. Lett. 88, (2006), 201918.

La diffusion de ces interstitiels intervient donc à des températures faibles par rapport à celles qui permettraient la diffusion des lacunes d'oxygène, dont l'énergie d'activation pour l'autodiffusion est plus importante, à savoir de l'ordre de 2 eV.

Les mesures « SIMS » mettent en évidence qu'il n'y a pas de diffusion de l'oxygène vers le SiO₂ déposé sur la surface du ZnO.

On peut donc penser que la silice est une barrière à l'exodiffusion de l'oxygène, alors qu'elle permet celle du Zinc.

Ceci donne donc un matériau avec une stoechiométrie riche en oxygène et pauvre en Zn sur une profondeur de quelques centaines de nm, par exemple de 50 à 500 nm sous l'interface SiO₂/ZnO.

Le procédé selon l'invention, grâce à la formation d'une phase cristalline riche en Zinc entre le ZnO et le SiO₂, permet donc de résoudre pour la première fois le problème lié à la forte énergie de formation des lacunes de Zn dans le ZnO qui rend difficile voire impossible la formation des complexes mentionnés ci-dessus.

Le procédé selon l'invention, grâce notamment à la succession des étapes a) et b) qu'il comporte, apporte pour la première fois une solution à ce problème qui apparaissait jusqu'alors insurmontable.

Le matériau ZnO ainsi obtenu à l'issue des étapes a) et b) du procédé selon l'invention voit sa stoechiométrie décalée et est donc susceptible d'être plus facilement « dopable » de type p par le biais de la formation des complexes accepteurs à faible énergie d'activation, associant lacunes de Zn et éléments accepteurs de la colonne V de la classification périodique des éléments tels que As, P et éventuellement Sb sur site Zn, comme cela a déjà été précisé plus haut.

Rappelons que la plupart des cristaux de ZnO ainsi que les couches épitaxiées sont obtenus dans des conditions riches en Zinc, ce qui induit la présence de lacunes d'oxygène et d'interstitiels de Zn, qui sont des impuretés intrinsèques dont le caractère donneur est rédhibitoire pour l'obtention du dopage p. Cette stoechiométrie riche en Zn est dictée par le procédé de croissance lui-même.

En résumé, on sait de manière générale que les impuretés dopantes doivent se placer sur un site donné du réseau cristallin ou impliquer des complexes entre ces impuretés et certains défauts natifs tels que des interstitiels ou lacunes.

Le procédé selon l'invention permet précisément de créer les défauts natifs nécessaires pour faciliter soit l'insertion de l'impureté dopante sur un site du réseau cristallin, dans la maille du réseau cristallin, soit la formation de complexes de l'impureté avec les lacunes du ZnO.

Le procédé selon l'invention repose sur la création de ces défauts natifs par formation d'une nouvelle phase cristalline stable à l'interface entre le ZnO et un autre matériau, à savoir la silice déposée sur le ZnO généralement sous la forme d'une couche.

Cette nouvelle phase déplace la stoechiométrie de la couche sous-jacente et permet de créer les défauts natifs nécessaires.

Le procédé selon l'invention permet la formation de lacunes de Zn dans le ZnO, et l'exodiffusion des interstitiels de Zn depuis le ZnO vers la silice, et ensuite ou simultanément l'insertion dans la maille du ZnO d'un élément dopant de la colonne V de la classification périodique des éléments ou la création de complexes à faible énergie d'activation de cet élément dopant avec les lacunes.

L'élément de la colonne V de la classification périodique des éléments peut être introduit dans le ZnO, par diffusion ou par implantation.

Selon un premier mode de réalisation du procédé selon l'invention, on réalise les étapes successives suivante :
- dépôt de silice, dopée par au moins un élément de la colonne V de la classification périodique des éléments, sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice; et simultanément une diffusion de l'élément de la colonne V de la classification périodique des éléments vers ladite partie du substrat adjacente à la silice et comprenant les lacunes de Zn.

Avantageusement, le recuit est effectué à une température de 700°C à 800°C, pendant une durée de 30 mn à 15 heures, de préférence sous une atmosphère d'oxygène ou d'air.

Selon un deuxième mode de réalisation du procédé selon l'invention, on réalise les étapes successives suivante :
- dépôt de silice non dopée sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice ;
- implantation d'au moins un élément dopant de la colonne V de la classification périodique des éléments au-travers de la silice dans ladite partie du substrat adjacente à la silice et comprenant les lacunes de zinc ;
- recuit du substrat implanté par les éléments dopants pour éliminer les défauts d'implantation et activer les éléments dopants (c'est-à-dire les mettre dans le bon site).

L'implantation est avantageusement faite à température ambiante (généralement 20°C à 25°C), pour une dose totale implantée entre 10^{E}13 et 10^{E}15 at/cm², et une énergie entre 50 et 200 keV.

Avantageusement, dans ce deuxième mode de réalisation du procédé selon l'invention, le recuit du substrat implanté est réalisé à une température de 700°C à 900°C pendant une durée de 15 mn à 2 heures, de préférence sous une atmosphère d'oxygène ou d' air.

Selon un troisième mode de réalisation du procédé selon l'invention, on réalise les étapes successives suivante :
- dépôt de silice non dopée sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice ;
- élimination de la silice ;
- diffusion d'au moins un élément dopant de la colonne V de la classification périodique des éléments dans ladite partie du substrat adjacente à la silice et comprenant les lacunes de Zinc ;
- recuit éventuel d'activation des dopants du substrat dans lequel a diffusé l'élément dopant.

Le recuit d'activation est ici éventuel, facultatif, car il se peut que la diffusion soit faite à des températures qui permettent de placer le dopant au bon endroit (de l'activer), mais si ce n'est pas le cas, un recuit postérieur d'activation est alors nécessaire.

Avantageusement, dans ce troisième mode de réalisation du procédé selon l'invention, l'élimination de la silice est réalisée par un procédé de gravure par les ions réactifs (« Reactive Ion Etching » ou « RIE » en langue anglaise), ou par un procédé de gravure chimique.

Avantageusement, dans ce troisième mode de réalisation du procédé selon l'invention, la diffusion d'au moins un élément dopant de la colonne V de la classification périodique des éléments, tel que l'arsenic ou le phosphore, est réalisée à partir d'une source solide ou vapeur dudit élément dopant ou d'un composé contenant ledit élément dopant.

Par exemple, la diffusion de l'As dans ZnO est typiquement effective dès 500°C .

Par exemple, le composé contenant l'arsenic est GaAs.

Avantageusement, dans ce troisième mode de réalisation du procédé selon l'invention, le recuit éventuel d'activation des dopants du substrat dans lequel a diffusé l'élément dopant est réalisé par un traitement à une température de 700°C à 900°C pendant une durée de 15 mn à 2 heures, de préférence sous une atmosphère d'oxygène ou d'air.

Ce recuit d'activation peut aussi être réalisé par une méthode de recuit rapide (dite « RTA » pour « Rapid Thermal Annealing ») à une température de 700°C à 800°C et pendant une durée de 10 à 300 secondes.

Le ZnO ou le ZnMgO dopé de type p préparé par le procédé selon l'invention peut notamment se présenter sous la forme d'une couche mince, notamment d'une couche mince 2D, par exemple d'une épaisseur de 50 nm à 500 nm, par exemple de 50 à 100 nm.

Cette couche mince, notamment cette couche mince 2D, de ZnMgO dopé de type p peut constituer une couche de surface d'un substrat massif, monolithique de type n et elle a alors une épaisseur généralement plutôt de 50 à 500 nm.

Dans le cas de nanofils, cette couche mince peut se trouver sur la partie supérieure des nanofils sur une épaisseur généralement de 50 à 500 nm et/ou sur la partie latérale des nanofils sur une épaisseur généralement de 50 à 100 nm.

Le ZnO ou le ZnMgO dopé de type n soumis au procédé selon l'invention peut en effet notamment se présenter sous la forme d'un substrat par exemple d'un substrat massif, monolithique, et lorsqu'il est soumis au procédé de l'invention, une couche de surface de ce substrat, par exemple de ce substrat massif, monolithique, est transformée respectivement en ZnO ou en ZnMgO dopé de type p. Cette couche de surface a généralement l'épaisseur mentionnée plus haut, à savoir une épaisseur de 50 à 500 nm.

Le substrat peut se présenter sous la forme de nanofils de type n et lorsqu'il est soumis au procédé de l'invention, une couche de surface de ces nanofils sur la partie supérieure et/ou la partie latérale des nanofils est transformée respectivement en ZnO ou en ZnMgO dopé de type p.

Cette couche de surface a généralement une épaisseur de 50 à 500 nm sur la partie supérieure des nanofils, et une épaisseur généralement de 50 à 100 nm sur la partie latérale des nanofils.

L'invention trouve notamment son application dans la préparation d'un substrat, ou structure, par exemple d'un substrat massif, monolithique, ou de nanofils, en ZnO ou en ZnMgO (non intentionnellement) dopé (s) de type n dont une couche de surface a été respectivement transformée en ZnO ou en ZnMgO dopé de type p par le procédé selon l'invention tel que décrit ci-dessus.

La couche de surface transformée en ZnO ou en ZnMgO dopé de type p a généralement une épaisseur de 100 nm à 500 nm, par exemple de 50 nm à 100 nm.

Une telle structure, compacte, monobloc présente des propriétés optiques et électriques modifiées sur une épaisseur comprise entre 100 nm et 500 nm. De telles propriétés n'avaient pas été obtenues jusqu'alors dans l'art antérieur.

Le procédé selon l'invention permet ainsi de créer des accepteurs présentant des propriétés optiques et électriques différentes sur une épaisseur donnée à partir d'un substrat en ZnO ou en ZnMgO non (intentionnellement) dopé de type n, par exemple d'un substrat monolithique en ZnO ou en ZnMgO non (intentionnellement) dopé de type n, ou de nanofils en ZnO ou en ZnMgO non (intentionnellement) dopé(s) de type n.

On peut ainsi facilement préparer par un procédé simple, et directement à partir d'un simple substrat monolithique ou de nanofils une jonction de type p-n sans faire appel par exemple à de multiples étapes de croissance.

L'invention trouve, en outre, son application dans le cadre d'une hétérostructure à puits quantiques de ZnO dans des couches d'alliages ZnMgO avec une couche inférieure de ZnMgO dopée de type n et une couche supérieure de ZnMgO non dopée transformée en ZnMgO de type p par le procédé selon l'invention.

L'invention trouve aussi son application dans le cadre d'un dispositif opto-électronique comprenant le ZnO ou le ZnMgO dopé de type p préparé par le procédé selon l'invention ou le substrat, en ZnO ou en ZnMgO (non intentionnellement) dopé de type n dont une couche de surface a été respectivement transformée en ZnO ou en ZnMgO dopé de type p par le procédé selon l'invention ou l'hétérostructure à puits quantique décrite plus haut.

Ce dispositif électronique peut notamment être une diode électroluminescente (DEL ou LED en langue anglaise) en particulier une DEL UV.

Le ZnO ou le ZnMgO dopé de type p préparé par le procédé selon l'invention ou le substrat décrit plus haut ou l'hétérostructure décrite plus haut peuvent être notamment utilisés en opto-électronique.

L'invention sera mieux comprise à la lecture de la description détaillée qui suit, faite notamment en référence avec les modes de réalisation préférés du procédé selon l'invention.

Cette description détaillée donnée à titre illustratif et non limitatif, est faite en référence aux dessins joints dans lesquels :

### BRÈVE DESCRIPTION DES DESSINS

- La Figure 1 est un graphique qui montre les analyses SIMS réalisées sur un substrat en ZnO sur lequel est déposée de la silice dopée au phosphore ayant subi un recuit à une température de 700°C ou à une température de 800°C pendant une durée de 5 heures ou de 15 heures.

Il est à noter que, sur la Figure 1 (et sur la Figure 2) les notations Cs + P, Cs + Zn et Cs + As sont utilisées, car en SIMS, on associe ion primaires et ions secondaires, en l'occurrence le césium pour les éléments électronégatifs tels que P, Zn, ou encore As.

La courbe A est l'analyse SIMS pour le phosphore réalisée sur un substrat ayant subi un recuit à une température de 700°C pendant une durée de 5 heures.

La courbe B est l'analyse SIMS pour le Zinc réalisée sur un substrat ayant subi un recuit à une température de 700°C pendant une durée de 5 heures.

La courbe C est l'analyse SIMS pour le phosphore réalisée sur un substrat ayant subi un recuit à une température de 700°C pendant une durée de 15 heures.

La courbe D est l'analyse SIMS pour le Zinc réalisée sur un substrat ayant subi un recuit à une température de 700°C pendant une durée de 15 heures.

La courbe E est l'analyse SIMS pour le phosphore réalisée sur un substrat ayant subi un recuit à une température de 800°C pendant une durée de 5 heures.

La courbe F est l'analyse SIMS pour le Zinc réalisée sur un substrat ayant subi un recuit à une température de 800°C pendant une durée de 5 heures.

La courbe G est l'analyse SIMS pour le phosphore réalisée sur un substrat ayant subi un recuit à une température de 800°C pendant une durée de 15 heures.

La courbe H est l'analyse SIMS pour le Zinc réalisée sur un substrat ayant subi un recuit à une température de 800°C pendant une durée de 15 heures.

En ordonnée est portée la détection (en coups/seconde) et en abscisse est portée la profondeur par rapport à la surface du SiO₂ en µm.
- La Figure 2 est un graphique qui montre les analyses SIMS réalisées sur un substrat en ZnO sur lequel est déposée de la silice dopée à l'arsenic ayant subi un recuit à une température de 700°C ou à une température de 800°C pendant une durée de 5 heures ou de 15 heures.

La courbe A est l'analyse SIMS pour le Zinc réalisée sur un substrat ayant subi un recuit à une température de 700°C pendant une durée de 5 heures.

La courbe B est l'analyse SIMS pour l'Arsenic réalisée sur un substrat ayant subi un recuit à une température de 700°C pendant une durée de 5 heures.

La courbe C est l'analyse SIMS pour le Zinc réalisée sur un substrat ayant subi un recuit à une température de 700°C pendant une durée de 15 heures.

La courbe D est l'analyse SIMS pour l'Arsenic réalisée sur un substrat ayant subi un recuit à une température de 700°C pendant une durée de 15 heures.

La courbe E est l'analyse SIMS pour le Zinc réalisée sur un substrat ayant subi un recuit à une température de 800°C pendant une durée de 5 heures.

La courbe F est l'analyse SIMS pour l'Arsenic réalisée sur un substrat ayant subi un recuit à une température de 800°C pendant une durée de 5 heures.

La courbe G est l'analyse SIMS pour le Zinc réalisée sur un substrat ayant subi un recuit à une température de 800°C pendant une durée de 15 heures.

La courbe H est l'analyse SIMS pour l'Arsenic réalisée sur un substrat ayant subi un recuit à une température de 800°C pendant une durée de 15 heures.

En ordonnée est portée la détection (en coups/seconde) et en abscisse est portée la profondeur par rapport à la surface du SiO₂ en µm.

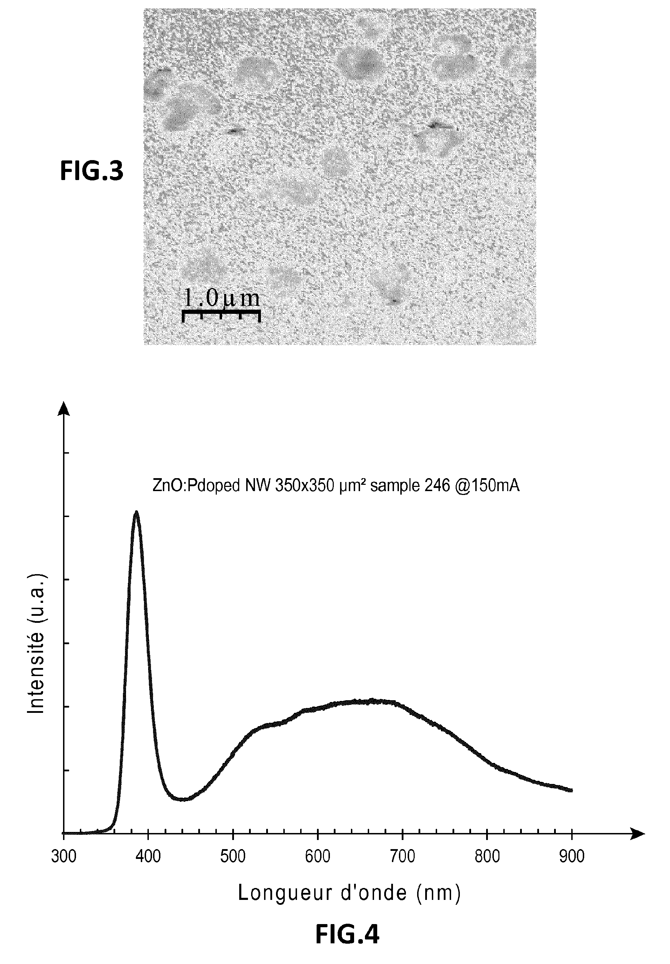

- La Figure 3 est une image obtenue lors de mesures de Capacitance par Microscopie à Force Atomique (« *Atomic Force Microscopy* » ou « *AFM* » en langue anglaise), en mode dit Microscopie Capacitive à Balayage (« Scanning Capacitance Microscopy » ou « SCM » en langue anglaise), d'un ensemble de nanofils encapsulés dans de la silice dopée P, et après un recuit à 800°C pendant une duré de 5 heures.

L'échelle portée sur la figure 3 représente 1,0 µm.
- La Figure 4 est le spectre d'électroluminescence d'un ensemble de nanofils de ZnO dopés dans leur partie supérieure par diffusion à partir d'une silice dopée au phosphore, par le procédé selon l'invention.
   En abscisse est portée la longueur d'onde (en nm), et en ordonnée est portée l'intensité (unités arbitraires, u.a.) ;
- La Figure 5 est une photographie qui montre l'émission optique d'une diode électroluminescente à nanofils dopés par diffusion dans leur partie supérieure.

### EXPOSÉ DÉTAILLÉ DE MODES DE RÉALISATION PARTICULIERS

Dans une première étape a) du procédé de préparation d'oxyde de zinc ZnO de type p ou de ZnMgO de type p selon l'invention, on dépose de la silice, éventuellement dopée par au moins un élément dopant de la colonne V de la classification périodique des éléments sur une surface d'un substrat en ZnO de type n ou en ZnMgO de type n.

Le substrat en ZnO ou ZnMgO peut se présenter sous la forme d'une couche mince, notamment d'une couche mince « 2D » d'une épaisseur généralement de 200 nm à 1 µm, ou d'un substrat « massif » monolithique, ou bien encore sous la forme de nanofils.

Les dimensions du substrat « massif » monolithique peuvent être généralement les dimensions que possèdent de tels substrats disponibles commercialement, avec un diamètre par exemple de 20 mm à 50,8 mm (2 pouces) et une épaisseur d'environ 500 µm.

La couche « 2D » est généralement préparée par un procédé de croissance épitaxiale sur un substrat généralement en Al₂O₃, en silicium ou en tout autre matériau permettant la croissance épitaxiale de ZnO.

Préférentiellement, les couches épitaxiales sont déposées sur un substrat massif de ZnO pour obtenir des couches épitaxiales sans défauts cristallins et donc une distribution homogène des dopants dans le matériau.

Le substrat massif est généralement issu de lingots monocristallins obtenus par un procédé de croissance hydrothermale ou toute autre technique de cristallogenèse connue de l'homme du métier.

Les nanofils de ZnO peuvent être élaborés sur tout type de support cristallin ou polycristallin ou même polymère.

Les nanofils peuvent être déposés par des techniques dites d'auto-organisation ou bien sur des substrats gravés de façon adéquate pour induire une croissance localisée et ordonnée desdits nanofils Leurs dimensions typiques sont un diamètre de 50 à 300 nm et une hauteur de 1 à 5 µm.

Il est à noter que la plupart des substrats massifs, cristaux, de ZnO ainsi que les couches épitaxiées et les nanofils sont obtenus dans des conditions riches en Zinc, ce qui induit la présence de lacunes d'oxygène et d'interstitiels de Zinc qui sont des impuretés intrinsèques, dont le caractère donneur est rédhibitoire pour l'obtention du dopage p. Cette stoechiométrie riche en Zinc est dictée par le procédé de croissance lui-même.

Ou bien, le substrat peut se présenter sous la forme d'une hétérostructure à puits quantiques de ZnO.

Une telle hétérostructure comporte généralement des puits quantiques de ZnO dans des couches, barrières d'alliages ZnMgO, par exemple de 1 à 5 couches ou barrières.

Cette hétérostructure peut être bi-dimensionnelle dans le cas de couches épitaxiées ou peut-être incluse dans des nanofils déposés sur un support dédié. Dans ce dernier cas, l'hétérostructure peut être dite axiale si l'empilement des couches successives se fait le long de l'axe des nanofils ou bien radiale si l'empilement des couches qui forment l'hétérostructure sont crus latéralement à partir des nanofils de ZnO initial.

L'hétérostructure comprend une couche, barrière inférieure de ZnMgO dopée de type n et une couche, barrière supérieure de ZnMgO non dopée sur la face supérieure de laquelle on effectue le dépôt de silice conformément au procédé de l'invention.

En mettant en oeuvre le procédé selon l'invention avec de tels substrats se présentant sous la forme d'hétérostructures déjà constituées, il est possible de former ainsi facilement la partie dopée p d'un dispositif électroluminescent, à condition toutefois que les températures de recuit considérées ne risquent pas d'induire de l'interdiffusion aux interfaces des puits quantiques.

Typiquement, la littérature fait mention d'hétérostructures à puits quantiques déposées à des températures avoisinant 800°C, sans qu'apparaissent des phénomènes d'interdiffusion aux interfaces entre le ZnMgO et les puits quantiques de ZnO (A. Lusson, J.V ac. Sci. Technol. B, 27(3),1755,2009), ce qui est donc compatible avec les températures de recuit utilisables pour induire la formation de lacunes de Zn sous le SiO₂.

Conformément au procédé selon l'invention dans son étape a), on dépose donc sur au moins une surface de l'échantillon, substrat, en ZnO, de la silice, éventuellement dopée par au moins un élément dopant de la colonne V de la classification périodique des éléments.

Le dépôt de silice peut prendre différentes formes.

Ce dépôt peut prendre notamment la forme d'une couche de silice, déposée de préférence sur la surface supérieure de la couche « 2D » ou sur une des surfaces du substrat massif, de préférence sur la surface supérieure du substrat massif.

Ce dépôt peut aussi se faire de façon conforme autour des nanofils c'est-à-dire sur leur partie supérieure et sur leur partie latérale.

Cette couche peut avoir une épaisseur de 50 à 500 nm, de préférence de 100 à 500 nm.

Le dépôt de la silice peut se faire par toute technique adéquate, par exemple par enduction centrifuge (« spin-coating »), ou par dépôt physique en phase vapeur « Physical Vapour Déposition » ou PVD en langue anglaise).

Dans le cas du premier mode de réalisation préféré du procédé selon l'invention, la silice déposée est dopée par au moins un élément dopant de la colonne V de la classification périodique des éléments.

La teneur en dopant de la silice déposée est généralement de 1% à 5%.

L'élément dopant de la colonne V de la classification périodique des éléments est généralement choisi parmi P, As et Sb.

L'étape b) suivante du procédé selon l'invention est une étape de recuit du substrat et de la silice déposée lors de l'étape a).

Conformément à l'invention, ce recuit est réalisé à une température suffisante et pendant une durée suffisante pour induire une exodiffusion du Zinc depuis le substrat en ZnO ou en ZnMgO vers la silice, et une formation de lacunes de Zinc dans au moins une partie du substrat.

Cette partie du substrat se présente généralement sous la forme d'une couche par exemple d'une épaisseur de 50 à 500 nm, de préférence de 50 à 100 nm, depuis l'interface entre la silice et le substrat en ZnO ou en ZnMgO. Cette épaisseur correspond généralement à l'épaisseur de la future zone p que l'on souhaite créer dans le substrat.

La profondeur sur laquelle le matériau est devenu p dépend étroitement des conditions de l'exodiffusion, donc de la température et des durées de recuit.

La température de recuit est généralement de 400°C à 1000°C, de préférence de 600°C à 950°C, de préférence encore de 700°C à 800°C.

De la même manière, la durée pendant laquelle est effectué le recuit de l'étape b) peut être facilement déterminée par l'homme du métier, et dépend là-encore, notamment de la nature et de la taille de l'échantillon de ZnO.

Cette durée est généralement de 30 mn à 15 heures.

Dans le cas qui est celui du premier mode de réalisation où une couche de silice dopée par un élément dopant de la colonne V de la classification périodique des éléments est déposée alors les conditions du recuit, température et durée sont choisies, pour également permettre la diffusion du dopant depuis le SiO₂ vers le ZnO et l'incorporation du dopant sur les sites du Zinc qui deviennent vacants. Ces conditions seront précisées plus bas dans le cadre de la description détaillée du premier mode de réalisation préféré du procédé selon l'invention.

Cette étape de recuit peut être réalisée dans une atmosphère d'oxygène ou à l'air, par exemple l'air ambiant.

Le procédé selon l'invention, outre la succession spécifique des étapes a) et b) décrites plus haut, comprend une étape de dopage du substrat par au moins un élément dopant de la colonne V de la classification périodique des éléments.

Cette étape de dopage peut être réalisée durant l'étape b), simultanément à l'étape b), ou bien à l'issue de l'étape b).

Le dopage peut être réalisé par tout procédé connu de l'homme du métier, par exemple par implantation d'au moins un ion d'un élément dopant ou bien par diffusion d'un élément dopant à partir d'une source solide ou vapeur.

Dans un premier mode de réalisation préféré du procédé selon l'invention, on réalise les étapes successives suivante :
- dépôt de silice, dopée par au moins un élément de la colonne V de la classification périodique des éléments sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et une formation de lacunes de Zinc dans au moins une partie du substrat ; et simultanément une diffusion de l'élément de la colonne V de la classification périodique des éléments vers les lacunes de Zn.

Le dépôt de la silice dopée est généralement réalisé comme on l'a déjà décrit plus haut de manière générale.

Ce premier mode de réalisation préféré du procédé selon l'invention peut être considéré comme le mode de réalisation préféré le plus simple du procédé selon l'invention.

Il consiste en effet à déposer à la surface du ZnO des silices dopées avec l'élément que l'on veut utiliser pour le dopage p du ZnO, par exemple P, As ou Sb.

Les conditions du recuit, notamment la température et la durée, sont choisies, dans ce premier mode de réalisation, non seulement de manière à induire l'exodiffusion du Zn et la formation de lacunes du zinc dans le ZnO comme c'est le cas dans le mode de réalisation le plus large du procédé selon l'invention, mais aussi pour permettre également et simultanément, la diffusion du dopant, par exemple P, As, ou Sb depuis le SiO₂ vers les lacunes du Zinc créées dans le ZnO et son incorporation sur les sites Zn qui sont ainsi devenus vacants.

Les conditions du recuit, et notamment température et durée, sont celles qui ont déjà été décrites plus haut de manière générale pour l'étape b). En effet, les conditions du recuit telles que température, durée, atmosphère etc. dans le cas d'une couche de silice dopée avec diffusion du dopant de la silice dans le ZnO sont généralement analogues à celles du recuit avec une couche de silice non dopée.

Dans un deuxième mode de réalisation préféré du procédé selon l'invention, on réalise les étapes successives suivante :
- dépôt de silice non dopée sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et une formation de lacunes de Zinc dans au moins une partie du substrat ;
- implantation d'au moins un élément dopant de la colonne V de la classification périodique des éléments au-travers de la silice dans ladite partie du substrat ;
- recuit éventuel d'activation du substrat implanté par les éléments dopants.

Dans ce deuxième mode de réalisation préféré du procédé selon l'invention, on réalise les étapes de dépôt a) et de recuit b) comme on l'a décrit plus haut dans le cas le plus général.

Le dépôt de silice se présente généralement sous la forme d'une couche dont l'épaisseur est généralement telle qu'on l'a déjà indiqué plus haut.

Le recuit est réalisé simplement à une température suffisante et pendant une durée suffisante pour induire une exodiffusion du Zinc depuis le substrat en ZnO ou en ZnMgO vers la silice, et une formation de lacunes de Zinc dans au moins une partie du substrat.

Comme on l'a déjà précisé plus haut, ces températures et durées suffisantes peuvent être facilement déterminées par l'homme du métier.

Cette température est généralement de 400°C à 1000°C, de préférence de 600°C à 950°C, de préférence encore de 700°C à 800°C et cette durée est généralement de 30 minutes à 15 heures.

A l'issue du recuit, le matériau riche en oxygène obtenu peut alors être dopé par implantation ionique au-travers de la couche de silice avec des éléments de la colonne V de la classification périodique des éléments tels que As, P ou Sb.

Les conditions de cette implantation peuvent être facilement déterminées par l'homme du métier.

L'implantation est avantageusement faite à température ambiante, pour des doses totales implantées entre 10^{E}13 et 10^{E}15 at/cm², et des énergies entre 50 et 200 keV.

Cette implantation est suivie d'un recuit d'implantation pour positionner les atomes de dopants sur les sites vacants en Zn et activer les dopants.

Les conditions de ce recuit, dit recuit d'implantation peuvent être facilement déterminées par l'homme du métier. Ce recuit d'implantation est généralement réalisé à une température de 700°C à 900°C pendant une durée de 15 minutes à 2 heures, sous atmosphère d'oxygène ou sous air.

A la différence de la diffusion, l'implantation permet d'ajuster le profil selon la profondeur de concentration de l'élément que l'on veut utiliser pour le dopage.

Le recuit post-implantation, en laissant la couche de SiO₂ à la surface du substrat, peut encore favoriser la formation des lacunes de Zn et donc celle des complexes accepteurs.

Dans un troisième mode de réalisation préféré du procédé selon l'invention, on réalise les étapes successives suivante :
- dépôt de silice non dopée sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et une formation de lacunes de Zinc dans au moins une partie du substrat ;

- élimination de la silice ;
- diffusion d'au moins un élément dopant de la colonne V de la classification périodique des éléments dans ladite partie du substrat ;
- recuit éventuel d'activation des dopants du substrat dans lequel a diffusé l'élément dopant.

Dans ce troisième mode de réalisation préféré du procédé selon l'invention, on réalise les étapes de dépôt a) et de recuit b) comme on l'a décrit plus haut dans le cas le plus général.

Le dépôt de silice se présente généralement sous la forme d'une couche dont l'épaisseur est généralement telle qu'on l'a déjà indiqué plus haut.

Le recuit est réalisé simplement à une température suffisante et pendant une durée suffisante pour induire une exodiffusion du Zinc depuis le substrat en ZnO ou en ZnMgO vers la silice, et une formation de lacunes de Zinc dans au moins une partie du substrat.

Comme on l'a déjà précisé plus haut, ces températures et durées suffisantes peuvent être facilement déterminées par l'homme du métier.

Cette température est généralement de 400°C à 1000°C, de préférence de 600°C à 950°C, de préférence encore de 700°C à 800°C, et cette durée est généralement de 30 mn à 15 heures.

A l'issue du recuit, on procède à l'élimination, au retrait de la silice, qui se présente généralement sous la forme d'une couche.

Le retrait, élimination de la silice peut se faire par tout procédé adéquat connu de l'homme du métier.

L'élimination, retrait de la silice peut se faire par un procédé de gravure, attaque, par voie sèche ou bien par un procédé de gravure attaque chimique par voie humide.

De préférence, on utilisera un procédé de gravure, attaque par voie sèche tel qu'un procédé de gravure par les ions réactifs (« Reactive Ion Etching » ou RIE en langue anglaise).

Après avoir retiré, éliminé, la silice, par exemple sous la forme d'une couche, on procède ensuite à la diffusion d'au moins un élément dopant de la colonne V de la classification périodique des éléments dans ladite partie du substrat dans laquelle ont été créées des lacunes de Zinc et qui est de ce fait riche en oxygène.

En d'autres termes, on réalise la diffusion d'au moins un élément dopant de la colonne V de la classification périodique des éléments tel que As, ou P, ou Sb sur la surface riche en oxygène qui a été créée à l'issue du recuit.

Cette diffusion peut se faire par voie solide ou gazeuse, c'est-à-dire que la diffusion de l'élément dopant, par exemple d'arsenic, de phosphore, ou d'antimoine, est réalisée à partir d'une source ou charge dudit élément dopant ou d'un composé contenant ledit élément dopant qui est en phase vapeur ou en phase solide.

On pourra, par exemple, dans une ampoule scellée à deux zones de chauffage, positionner une charge de GaAs dans la partie chaude et la porter à une température par exemple de 550°C ; et positionner le substrat de ZnO dans la partie « froide », par exemple à 500°C, et ce pendant une durée typiquement entre 3 mn et 2 heures, de façon à induire la diffusion de l'arsenic issu de la décomposition thermique de la charge de GaAs.

Après la diffusion de l'élément dopant, on peut éventuellement procéder à un recuit, dit recuit d'activation du substrat dans lequel a diffusé l'élément dopant.

Les conditions de ce recuit, dit recuit d'activation des éléments, espèces dopantes, peuvent être facilement déterminées par l'homme du métier.

Le recuit d'activation des dopants du substrat dans lequel a diffusé l'élément dopant peut être réalisé à une température de 700°C à 900°C pendant une durée de 15 minutes à 2 heures sous atmosphère d'oxygène ou à l'air.

Ce recuit d'activation peut aussi être réalisé par une méthode de recuit rapide (dite « RTA » pour « Rapid Thermal Annealing ») à des températures généralement entre 700°C et 800°C et pour des durées entre 10 et 300 secondes.

L'invention va maintenant être décrite en référence aux exemples suivants, donnés à titre illustratif et non limitatif.

Ces exemples font référence aux figures jointes, déjà décrites plus haut

### EXEMPLES.

### Exemple 1.

Les graphiques des Figures 1 et 2 représentent des mesures de spectrométrie de masse d'ions secondaires (SIMS) obtenues sur des échantillons composés d'un substrat de ZnO recouvert d'une couche de silice d'épaisseur 250nm, après différents recuits à des températures de 700°C et 800°C pour des durées s'étalant de 5 heures à 15 herues. Il apparaît clairement que les recuits induisent une exodiffusion du Zn vers la silice et du phosphore (Figure 1) ou de l'arsenic (Figure 2), ces deux types de diffusion augmentant avec la température de recuit et avec la durée de recuit. L'exodiffusion du Zn vers la silice correspond à la formation de lacunes de Zn dans le substrat de ZnO.

### Exemple 2.

L'image de la Figure 3 représente des mesures de capacitance locale (en mode dit « Microscopie Capacitive à *Balayage* » « *Scanning* Capacitance *Microscopy* » ou « SCM » en langue anglaise) d'un Microscope à Force Atomique (« *Atomic Force Microscopy* » ou « *AFM* » en langue anglaise) de la surface supérieure de nanofils de ZnO encapsulés dans SiO₂ dopé au P et recuit à 800°C pendant 5 heures (premier mode de réalisation).

Ces nanofils de ZnO encapsulés dans SiO₂ dopé au P sont des nanofils préparés de la manière suivante :
Des nanofils de ZnO ayant une longueur entre 1 et 5 µm, et un diamètre entre 100 et 300 nm, ont été déposés par Epitaxie en Phase Vapeur d'Organométalliques sur des substrats de saphir.

Un dépôt de silice non dopée a été effectué par dépôt en phase vapeur sur l'ensemble des nanofils, suivi d'une étape de planarisation après polissage mécanochimique, et d'une étape de gravure pour révéler la partie supérieure des nanofils.

Finalement, un dépôt de silice dopée P a été effectué par dépôt en phase vapeur sur la surface ainsi préparée, suivi d'un recuit à 800°C pendant 30 minutes.

Il apparaît que le signal de capacitance obtenu est révélateur d'un type p dans les nanofils initialement de type n, montrant que le procédé tel que décrit dans l'invention a été effectivement mis en oeuvre avec succès.

### Exemple 3.

La Figure 4 représente une courbe d'électroluminescence d'un ensemble de nanofils de ZnO dopés, dans leur partie supérieure, par diffusion de phosphore à partir d'une silice dopée avec cet élément, la partie inférieure des nanofils n'ayant pas été dopée. L'électroluminescence est bien centrée à 380 nm, telle qu'on peut l'attendre d'une homojonction ZnO p/n. Ceci est une preuve également que le dopage par diffusion dans la partie haute du nanofil est bien effectif (premier mode de réalisation).

Ces nanofils de ZnO sont des nanofils préparés de la manière suivante :
Des nanofils de ZnO ayant une longueur entre 1 et 5 µm, et un diamètre entre 100 et 300 nm, ont été déposés par Epitaxie en Phase Vapeur d'Organométalliques sur des substrats de saphir.
Un dépôt de silice non dopée a été effectué par dépôt en phase vapeur sur l'ensemble des nanofils, suivi d'une étape de planarisation après polissage mécanochimique, et d'une étape de gravure pour révéler la partie supérieure des nanofils.

Finalement, un dépôt de silice dopée P a été effectué par dépôt en phase vapeur sur la surface ainsi préparée, suivi d'un recuit à 800°C pendant 30 minutes.

### Exemple 4.

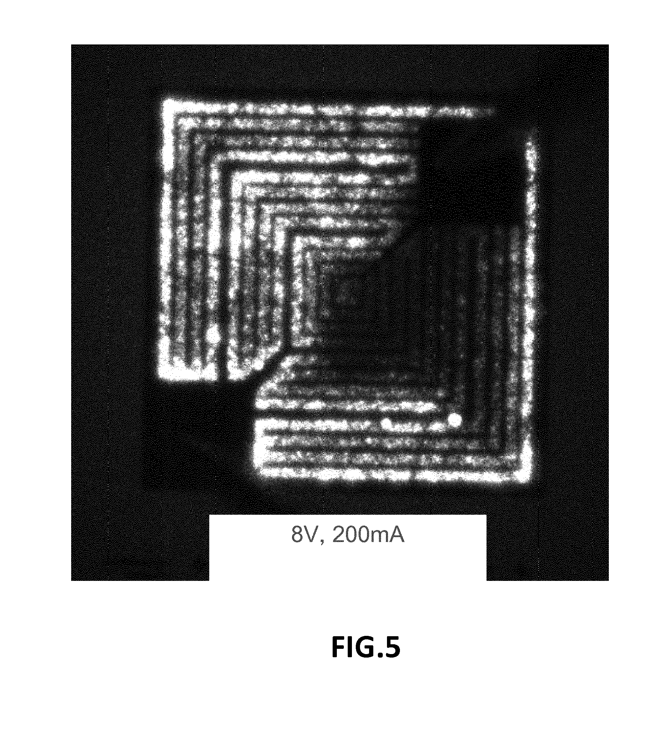

La photographie de la Figure 5 montre l'émission optique d'une diode électroluminescente à nanofils dopés par diffusion dans leur partie supérieure.

Ces nanofils sont des nanofils préparés de la même manière que dans l'exemple 3.

## Revendications

1. Procédé de préparation d'oxyde de zinc ZnO de type p ou de ZnMgO de type p, comprenant au moins la succession des deux étapes a) et b) suivante :
a) dépôt de silice, éventuellement dopée par au moins un élément dopant de la colonne V de la classification périodique des éléments, sur une surface d'un substrat en ZnO de type n ou en ZnMgO de type n ;
b) recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice ; et
une étape de dopage de ladite partie du substrat adjacente à la silice et comprenant les lacunes de Zinc par au moins un élément dopant de la colonne V de la classification périodique des éléments durant l'étape b) ou à l'issue de l'étape b).

2. Procédé selon la revendication 1, dans lequel le substrat en ZnO de type n ou en ZnMgO de type n se présente sous la forme d'un substrat massif monolithique, d'une couche, par exemple d'une couche épitaxiée, d'au moins un nanofil, ou d'une hétérostructure à puits quantiques de ZnO.

3. Procédé selon la revendication 2, dans lequel le substrat se présente sous la forme d'une hétérostructure à puits quantique de ZnO dans des couches d'alliages ZnMgO avec une couche inférieure de ZnMgO dopée de type n et une couche supérieure de ZnMgO non dopée sur la face supérieure de laquelle on effectue le dépôt de silice.

4. Procédé selon l'une quelconque des revendications précédentes, dans lequel l'élément dopant de la colonne V de la classification périodique des éléments est choisi parmi P, As et Sb.

5. Procédé selon l'une quelconque des revendications précédentes, dans lequel le dépôt de silice est réalisé sous la forme d'une couche, l'épaisseur de ladite couche étant de préférence de 50 à 500 nm, de préférence encore de 100 à 500 nm.

6. Procédé selon l'une quelconque des revendications précédentes, dans lequel lors de l'étape b), le recuit est réalisé à une température de 400°C à 1000°C, de préférence de 600°C à 950°C, de préférence encore de 700°C à 800°C, pendant une durée de 30 mn à 15 heures.

7. Procédé selon l'une quelconque des revendications précédentes, dans lequel ladite partie du substrat adjacente à la silice s'étend sur une épaisseur de 50 à 500 nm depuis une interface entre la silice et le ZnO ou le ZnMgO.

8. Procédé selon l'une quelconque des revendications précédentes, dans lequel le dopage de ladite partie du substrat adjacente à la silice par au moins un élément dopant de la colonne V de la classification périodique des éléments est réalisé par diffusion ou par implantation dudit élément.

9. Procédé selon l'une quelconque des revendications 1 à 8, dans lequel on réalise les étapes successives suivante :
- dépôt de silice, dopée par au moins un élément de la colonne V de la classification périodique des éléments, sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice; et simultanément une diffusion de l'élément de la colonne V de la classification périodique des éléments vers ladite partie du substrat adjacente à la silice et comprenant les lacunes de Zn.

10. Procédé selon la revendication 9, dans lequel le recuit est effectué à une température de 700°C à 800°C, pendant une durée de 30 minutes à 15 heures, de préférence sous une atmosphère d'oxygène ou d'air.

11. Procédé selon l'une quelconque des revendications 1 à 8, dans lequel on réalise les étapes successives suivante :
- dépôt de silice non dopée sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice ;
- implantation d'au moins un élément dopant de la colonne V de la classification périodique des éléments au-travers de la silice dans ladite partie du substrat adjacente à la silice et comprenant les lacunes de zinc ;
- recuit du substrat implanté par les éléments dopants pour éliminer les défauts d'implantation et activer les éléments dopants.

12. Procédé selon la revendication 11, dans lequel l'implantation est faite à température ambiante, pour une dose totale implantée entre 10^{E}13 et 10^{E}15 at/cm², et une énergie entre 50 et 200 keV.

13. Procédé selon la revendication 11 ou 12, dans lequel le recuit du substrat implanté est réalisé à une température de 700°C à 900°C pendant une durée de 15 minutes à 2 heures, de préférence sous une atmosphère d'oxygène ou d'air.

14. Procédé selon l'une quelconque des revendications 1 à 8, dans lequel on réalise les étapes successives suivante :
- dépôt de silice non dopée sur une surface d'un substrat en ZnO de type n ou en ZnMgO de type n ;
- recuit du substrat et de la silice déposée à une température suffisante et pendant une durée suffisante pour induire une exodiffusion du Zinc depuis le substrat en ZnO ou en ZnMgO vers la silice, et la formation de lacunes de Zinc dans au moins une partie du substrat adjacente à la silice ;
- élimination de la silice ;
- diffusion d'au moins un élément dopant de la colonne V de la classification périodique des éléments dans ladite partie du substrat adjacente à la silice et comprenant les lacunes de Zinc ;
- recuit éventuel d'activation des dopants du substrat dans lequel a diffusé l'élément dopant.

15. Procédé selon la revendication 14, dans lequel l'élimination de la silice est réalisée par un procédé de gravure par les ions réactifs (« Reactive Ion Etching » ou « RIE » en langue anglaise) ou par un procédé de gravure chimique.

16. Procédé selon la revendication 14 ou 15, dans lequel la diffusion d'au moins un élément dopant de la colonne V de la classification périodique des éléments, tel que l'arsenic ou le phosphore, est réalisée à partir d'une source solide ou vapeur dudit élément dopant ou d'un composé contenant ledit élément dopant.

17. Procédé selon l'une quelconque des revendications 14 à 16, dans lequel le recuit éventuel d'activation des dopants du substrat dans lequel a diffusé l'élément dopant est réalisé par un traitement à une température de 700°C à 900°C pendant une durée de 15 minutes à 2 heures, de préférence sous une atmosphère d'oxygène ou d'air ; ou par une méthode de recuit rapide (dite « RTA » pour « Rapid Thermal Annealing ») à une température de 700°C à 800°C et pendant une durée de 10 à 300 secondes.
